(19) Europäisches Patentamt
European Patent Office
Office européen des brevets

(11) **EP 4 336 860 B1**

(12) **FASCICULE DE BREVET EUROPEEN**

(45) Date de publication et mention de la délivrance du brevet:
**01.01.2025 Bulletin 2025/01**

(21) Numéro de dépôt: **23194096.6**

(22) Date de dépôt: **29.08.2023**

(51) Classification Internationale des Brevets (IPC):
*H04R 1/28* (2006.01)      *H04R 1/02* (2006.01)
*H04R 9/02* (2006.01)      *H04R 1/06* (2006.01)

(52) Classification Coopérative des Brevets (CPC):
**H04R 1/2826;** H04R 1/028; H04R 1/06;
H04R 9/022; H04R 2201/028

(54) **EVENT DISSIPATEUR THERMIQUE**

WÄRMESENKE-ENTLÜFTUNG

HEAT DISSIPATING VENT

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **08.09.2022 FR 2208968**

(43) Date de publication de la demande:
**13.03.2024 Bulletin 2024/11**

(73) Titulaire: **Sagemcom Broadband SAS**
**92270 Bois-Colombes (FR)**

(72) Inventeurs:
- **BOUVIGNE, Gabriel**
  **92500 RUEIL MALMAISON (FR)**
- **MARTIN DE MONTAUDRY, Charles-Efflam**
  **92500 RUEIL MALMAISON (FR)**
- **BOURGOIN, Gilles**
  **92500 RUEIL MALMAISON (FR)**

(74) Mandataire: **Cabinet Boettcher et al**
**5, rue de Vienne**
**75008 Paris (FR)**

(56) Documents cités:
FR-A1- 2 394 220     FR-A1- 3 075 546
JP-A- 2003 061 177    JP-A- H10 164 680
US-A1- 2020 314 546

**Description**

L'invention concerne le domaine des équipements électriques intégrant une enceinte acoustique.

ARRIERE PLAN DE L'INVENTION

De nombreux équipements électriques modernes intègrent une enceinte acoustique comprenant un caisson et un haut-parleur, ainsi que divers composants électroniques. Parmi ces équipements électriques, on trouve notamment des boîtiers décodeurs « améliorés », des enceintes connectées, des assistants vocaux, etc.

La conception généralement très compacte de ces équipements nécessite d'intégrer toutes leurs fonctionnalités dans un volume réduit. En particulier, la présence du caisson acoustique réduit le volume disponible pour intégrer les composants électroniques des différentes fonctions (acoustiques et autres). Le volume d'air autour des composants électroniques est donc réduit, ce qui nuit au refroidissement desdits composants électroniques et engendre des problématiques importantes de diffusion thermique.

On intègre donc dans l'équipement électrique des dispositifs dédiés à la diffusion et à l'évacuation thermiques, tels que des radiateurs ou des dissipateurs. L'efficacité de ces dispositifs est généralement insuffisante et ce, d'autant que le volume qui leur est consacré est lui aussi réduit. L'utilisation d'un ventilateur semble problématique du fait des contraintes d'intégration et des possibles perturbations générées dans les signaux audio restitués par l'enceinte acoustique.

Il est connu du document brevet US2020/314546 un équipement comportant une enceinte acoustique comprenant un caisson, un haut-parleur et un évent.

D'autres équipements sont également connus des documents FR3075546A1, FR2394220A1 et JPH10164680A.

OBJET DE L'INVENTION

L'invention a pour objet d'améliorer la dissipation thermique dans un équipement électrique intégrant une enceinte acoustique.

RESUME DE L'INVENTION

En vue de la réalisation de ce but, on propose un équipement selon la revendication 1. Un tel équipement comporte :

- une enceinte acoustique comprenant un caisson, un haut-parleur et un évent ;
- un composant électronique ;
- un dispositif de dissipation thermique agencé pour dissiper une chaleur générée par le composant électronique, et comprenant l'évent ainsi qu'un élément conducteur thermique qui s'étend depuis une extrémité de l'évent et qui est couplé thermiquement avec le composant électronique.

La partie tubulaire de l'évent forme une surface de dissipation additionnelle qui s'ajoute à celle de l'élément conducteur thermique. De plus, en fonctionnement, la surface de l'évent est au contact d'un écoulement d'air important, ce qui améliore encore la dissipation de la chaleur produite par le composant électronique.

On propose de plus un équipement tel que précédemment décrit, dans lequel l'élément conducteur thermique comprend une plaque qui s'étend dans un plan perpendiculaire à un axe longitudinal de l'évent, et dans lequel l'évent s'évase au niveau de ladite extrémité pour déboucher sur ladite plaque conductrice.

On propose de plus un équipement tel que précédemment décrit, dans lequel le composant électronique est monté sur une carte électrique qui s'étend entre la plaque et une face du caisson, parallèlement à ladite plaque et à ladite face.

On propose de plus un équipement tel que précédemment décrit, dans lequel l'évent, lorsqu'il est vu en coupe selon un plan perpendiculaire à un axe longitudinal de l'évent, présente une forme oblongue.

On propose de plus un équipement tel que précédemment décrit, dans lequel l'évent comprend des ailettes qui s'étendent depuis une surface interne de l'évent et parallèlement à un axe longitudinal de l'évent.

On propose de plus un équipement tel que précédemment décrit, dans lequel une distance $e$ entre deux ailettes adjacentes est telle que :

$$e > 2 * h$$

où $h$ est une hauteur desdites ailettes.

On propose de plus un équipement tel que précédemment décrit, dans lequel une hauteur de chaque ailettes va en diminuant en se rapprochant des extrémités de l'évent.

L'équipement selon l'invention comprend un passage de câble formé sur ou dans une ailette, ou entre deux ailettes adjacentes, le passage de câble s'étendant selon une longueur de ladite ou desdites ailettes.

On propose de plus un équipement tel que précédemment décrit, dans lequel le passage de câble comprend une gorge formée au niveau d'une surface d'une ailette, ladite surface étant opposée à la surface interne de l'évent depuis laquelle s'étend ladite ailette.

On propose de plus un équipement tel que précédemment décrit, comprenant une pluralité d'évents ayant des axes longitudinaux parallèles.

On propose de plus un équipement tel que précédemment décrit, dans lequel la pluralité d'évents comporte au moins deux évents comprenant chacun une paroi en contact ou confondue avec une paroi de l'autre évent.

On propose de plus un équipement tel que précédemment décrit, dans lequel l'élément conducteur thermique comprend une plaque formant une portion ou la totalité d'une face du caisson.

On propose de plus un équipement tel que précédemment décrit, dans lequel le couplage thermique entre l'élément conducteur thermique et le composant électronique est réalisé par un moyen de liaison thermique positionné entre l'élément conducteur thermique et le composant électronique.

On propose de plus un équipement tel que précédemment décrit, l'équipement étant un boîtier décodeur.

L'invention sera mieux comprise à la lumière de la description qui suit de modes de mise en oeuvre particuliers non limitatifs de l'invention.

BREVE DESCRIPTION DES DESSINS

Il sera fait référence aux dessins annexés parmi lesquels :

[Fig. 1] la figure 1 représente une vue en coupe, selon un plan vertical, d'un équipement électrique selon un mode de réalisation ;

[Fig. 2] la figure 2 représente une enceinte de l'art antérieur sans évent et une enceinte de l'art antérieur avec évent ;

[Fig. 3] la figure 3 représente les réponses en fréquence des enceintes de la figure 2 ;

[Fig. 4] la figure 4 représente une vue de dessus du caisson et du dispositif de dissipation thermique ;

[Fig. 5] la figure 5 représente une vue en coupe d'une portion de l'évent, selon un plan perpendiculaire à l'axe longitudinal de l'évent ;

[Fig. 6] la figure 6 représente une vue en coupe d'une ailette et d'une extrémité de l'évent, selon un plan comprenant l'axe longitudinal de l'évent ;

[Fig. 7] la figure 7 représente une vue en coupe d'une ailette et d'un câble selon un plan perpendiculaire à un axe longitudinal de ladite ailette ;

[Fig. 8] la figure 8 représente une vue en coupe, selon un plan vertical, d'un équipement électrique selon un autre mode de réalisation ;

[Fig. 9] la figure 9 représente une vue de dessus du caisson et du dispositif de dissipation thermique selon un autre mode de réalisation.

DESCRIPTION DETAILLEE DE L'INVENTION

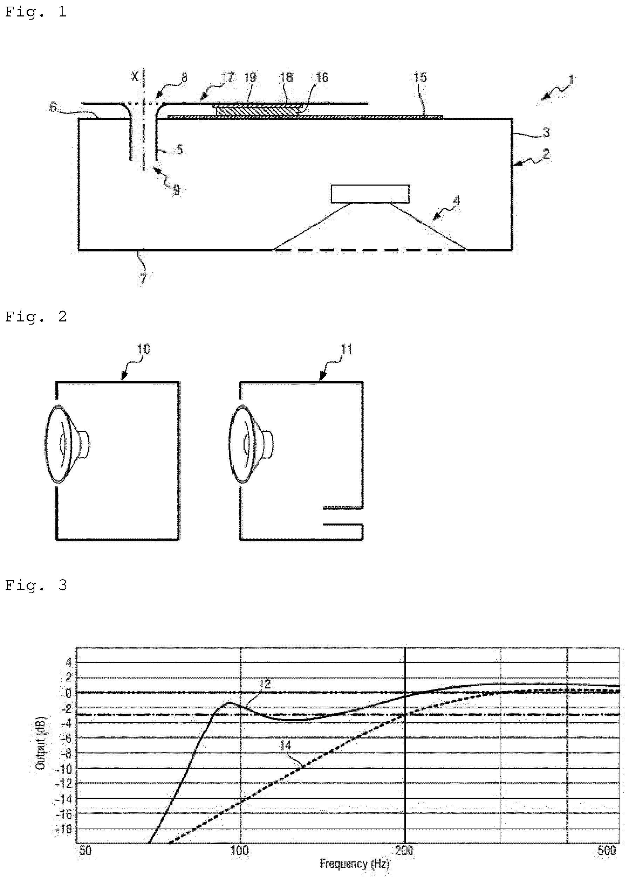

En référence à la figure 1, l'invention est ici mise en oeuvre dans un boîtier décodeur 1 (ou STB, pour *Set-Top Box*). Le boîtier décodeur 1 est en l'occurrence un boîtier décodeur « amélioré » qui comprend, outre les composants électroniques lui permettant de mettre en oeuvre les fonctions habituelles d'un boîtier décodeur, une enceinte acoustique 2 lui permettant de restituer des signaux audio vers l'extérieur.

L'enceinte acoustique 2 comprend un caisson 3, un haut-parleur 4 et un évent 5. Le haut-parleur 4 est ici un haut-parleur des graves reproduisant les basses fréquences (*woofer*).

L'évent 5 s'étend au travers de la face 6 (face supérieure du caisson 3) qui est opposée à la face 7 (face inférieure) au niveau de laquelle est intégrée la membrane du haut-parleur 4.

L'axe longitudinal X de l'évent 5 est perpendiculaire à la face 6 (et à la face 7).

L'évent 5 comprend une extrémité 8 située à l'extérieur du caisson 3 et une extrémité 9 située à l'intérieur du caisson 3.

De manière générale, les performances d'une enceinte acoustique dans les basses fréquences sont améliorées par l'ajout dans le caisson d'un tel évent. On parle donc d'une enceinte de type « bass-reflex ». L'air qui circule dans l'évent entre l'intérieur du caisson et l'extérieur forme un système mécanique qui résonne à une fréquence spécifique.

On voit sur la figure 2 une enceinte 10 et une enceinte 11, qui sont des enceintes de l'art antérieur. L'enceinte 10 est une enceinte close alors que l'enceinte 11 comprend un évent. La conception bass-reflex améliore les performances de l'enceinte dans les basses fréquences, sans avoir besoin d'avoir recours à un élément mécanique supplémentaire (tel qu'un radiateur passif) et sans nécessiter un déboitement trop important de la membrane du haut-parleur (le déboitement étant contraint à la fois par les caractéristiques mécaniques de la membrane et par la conception externe de l'équipement).

En référence à la figure 3, on voit que la réponse 12 d'une enceinte de conception bass-reflex est augmentée dans les basses fréquences par rapport à la réponse 14 d'une enceinte dite « en charge close », c'est-à-dire ayant un volume fermé, sans évent.

L'augmentation de la réponse dans les basses fréquences est due à la forme tubulaire de l'évent, qui, couplée au volume interne de l'enceinte, agit comme un résonnateur de Helmholtz. La fréquence de résonance de ce système est donnée par la formule suivante :

$$f_{BassReflex} = \frac{c}{2\pi}\sqrt{\frac{S}{(L + K\sqrt{S}).V}}$$

où c est la célérité du son dans l'air ($c = 340\ m.s^{-1}$), $L$ est la longueur de l'évent (selon son axe longitudinal $X$), V est le volume du caisson de l'enceinte, $K$ est un coefficient de correction d'extrémité et $S$ la section (surface de la section) de l'évent. Dans le cas fréquent d'un évent circulaire, la section est égale à l'aire du cercle, soit $S = \pi.r^2$ avec $r$ le rayon du cercle.

On revient à l'invention et à la figure 1. Le boîtier décodeur 1 comprend de plus une ou des cartes électriques sur lesquelles sont montés des composants électroniques. Parmi ces cartes électriques, la carte 15 est montée à l'extérieur du caisson 3 en étant positionnée parallèlement à la face 6 contre une paroi externe de ladite face 6. La carte 15 est fixée à la face 6. La carte 15 comprend notamment un composant électronique 16 qui est ici un composant qui s'échauffe en fonctionnement de manière relativement importante. Il peut s'agir de tout type de composant, et par exemple d'un SoC (pour *System on a Chip,* ou système sur une puce), d'un processeur, d'un transmetteur radio, d'un amplificateur, etc.

Le boîtier décodeur 1 comporte de plus un dispositif de dissipation thermique 17 qui est destiné à améliorer la dissipation thermique du boîtier décodeur 1 et, en particulier, à dissiper la chaleur générée par le composant 16 en fonctionnement.

Le dispositif de dissipation thermique 17 comprend l'évent 5 ainsi qu'un élément conducteur thermique qui s'étend depuis l'extrémité 8 de l'évent 5 et qui est couplé thermiquement avec le composant électronique 16.

L'élément conducteur thermique est ici une plaque rectangulaire 18 qui s'étend dans un plan perpendiculaire à l'axe longitudinal X de l'évent 5. L'évent 5 s'évase au niveau de l'extrémité 8 pour déboucher sur ladite plaque 18. Ici, l'évent 5 et la plaque 18 forment une pièce unique (mais ce n'est pas nécessairement le cas).

Cette pièce est fabriquée avec un (ou des) matériau rigide, comme par exemple de l'aluminium ou un plastique de type ABS (pour Acrylonitrile Butadiène Styrène), pour que la section de l'évent 5 reste constante malgré les variations de pression, et permettant une bonne conduction thermique.

La plaque 18 s'étend à l'extérieur du caisson 3 en étant parallèle à la face 6 du caisson 3. La carte électrique 15 et le composant électronique 16 sont positionnés entre la plaque conductrice 18 et la face 6 du caisson 3. La plaque 18 s'étend sur une surface majoritaire de la face 6 du caisson 3 et, en particulier, recouvre l'intégralité de la surface du composant 16.

Le dispositif de dissipation thermique 17 comprend de plus un moyen de liaison thermique entre la surface du composant 16 et la plaque 18, permettant de les coupler thermiquement.

Le moyen de liaison thermique comprend ici un pad thermique 19 qui est positionné entre le composant électronique 16 et la plaque thermique 18 en étant en contact avec ces deux éléments.

Le dispositif de dissipation thermique 17 permet donc de dissiper la chaleur produite par le composant électronique 16.

L'évent 5 est utilisé comme surface de dissipation. Cette surface est au contact direct d'un écoulement d'air important, dans un sens puis dans l'autre, lors du fonctionnement du haut-parleur 4 : l'air est déplacé à grande vitesse dans l'évent 5 lors des émissions sonores.

La forme de l'évent 5 est conçue pour maximiser la surface de contact avec l'air.

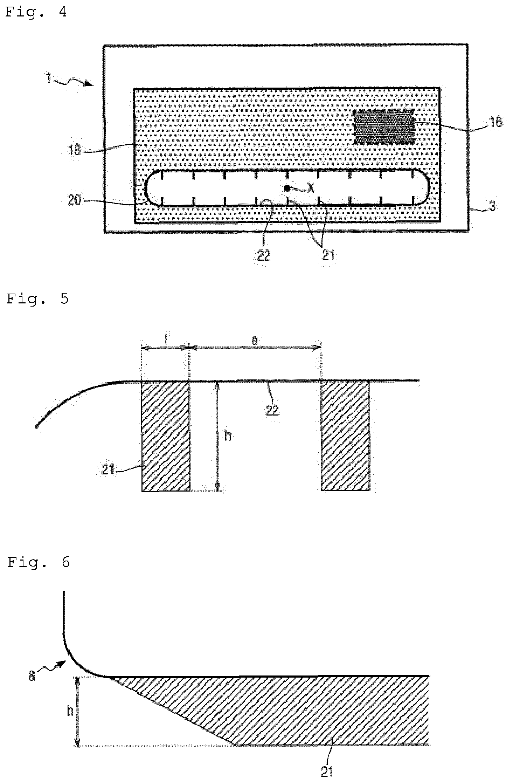

En référence à la figure 4, l'évent 5 présente une forme cylindrique de section oblongue : l'évent 5, lorsqu'il est vu en coupe selon un plan perpendiculaire à son axe longitudinal X, présente une forme oblongue.

Ainsi, le contour 20 de l'évent 5 présente la forme d'un rectangle dont les largeurs sont arrondies et dont les longueurs sont parallèles à la longueur du boîtier décodeur 1.

Cette forme allongée de la section de l'évent 5, plutôt que circulaire, permet de réduire le diamètre de l'évent 5 dans sa plus petite dimension (« largeur » de l'évent 5), ce qui réduit la profondeur du boîtier décodeur 1 tout en augmentant la surface de contact entre l'évent 5 et l'air pour un même volume d'air (à surface constante, le périmètre de l'évent 5 est augmenté). Cette forme allongée permet donc d'améliorer les échanges thermiques tout en diminuant l'encombrement du boîtier décodeur 1.

De plus, la périphérie de l'évent 5 est garnie d'ailettes 21. Les ailettes 21 s'étendent depuis une surface interne 22 de l'évent 5 et parallèlement à l'axe longitudinal X de l'évent 5. Les ailettes 21 permettent d'augmenter encore la surface de contact avec l'air.

La réduction de la section efficace de l'évent 5 engendrée par la présence des ailettes 21 doit être compensée par une augmentation de ses dimensions (comparativement à un évent 5 sans ailettes). La nouvelle fréquence de résonance de l'évent dissipateur $f_{event}$ est alors donnée par :

$$f_{event} = \frac{c}{2\pi} \sqrt{\frac{S_{efficace}}{(L + K\sqrt{S_{efficace}}).V}}$$

où $S_{efficace} = S - S_{ailette}.N_{ailette}$ avec $S_{ailette}$ est la section d'une ailette 21 et $N_{ailette}$ le nombre d'ailettes 21 intégrées dans l'évent 5.

L'augmentation nécessaire des dimensions de l'évent 5 est relativement faible, car la présence des ailettes 21 influe peu sur la section de l'évent 5. Les ailettes 21 permettent cependant d'obtenir une augmentation importante du périmètre de l'évent 5, et donc de la surface d'échange entre le dispositif de dissipation thermique 17 et l'air. Cependant, pour maximiser la puissance thermique extraite en sortie d'évent 5, il est essentiel que l'air circule convenablement entre les ailettes 21 : le profil de vitesse de l'air doit être le plus uniforme possible dans la section de l'évent 5, en entrée et en sortie. En outre, si l'air ne circule pas convenablement entre les ailettes 21, la section efficace de l'évent 5 sera réduite et la fréquence de résonance du bass-reflex ne correspondra plus à celle qui a été calculée pour l'enceinte 2.

Ainsi, en référence à la figure 5, afin de minimiser l'influence sur la circulation de l'air, les dimensions et la position des ailettes 21 doivent être de préférence choisies de sorte que la distance e entre deux ailettes 21 adjacentes soit supérieure à la hauteur **h** desdites ailettes 21.

Avantageusement, on a : *e > 2 * h.*

La largeur *l* de chaque ailette 21 doit être de préférence choisie la plus petite possible, même si elle n'a que très peu d'influence sur l'augmentation du périmètre de l'évent 5. Ces critères permettent également d'éviter les perturbations acoustiques lorsque l'air circule à grande vitesse entre deux ailettes 21 (de telles perturbations peuvent générer des sifflements).

De plus, il est préférable de ne pas avoir d'arêtes vives en entrée et en sortie d'évent, car les arêtes vives sont sources de turbulences lors de l'écoulement du flux d'air.

En référence à la figure 6, la hauteur *h* des ailettes 21 va en diminuant en se rapprochant de chacune des extrémités 8, 9 de l'évent 5. Chaque ailette 21 comprend, dans sa longueur, une portion centrale de hauteur continue et deux portions extrémales dont la hauteur diminue vers l'extrémité concernée de l'ailette (et donc de l'évent).

Chaque extrémité de l'ailette 21, lorsqu'elle est vue en coupe selon un plan comprenant l'axe longitudinal X de l'évent 5, a donc la forme d'une pente qui descend vers l'extrémité la plus proche de l'évent 5. Chaque ailette 21 est donc profilée et s'affine en entrée et en sortie d'évent 5, ce qui permet d'éviter les turbulences. Le chanfrein ainsi formé permet d'éviter que l'ailette 21 n'agisse comme un obstacle à l'écoulement de l'air.

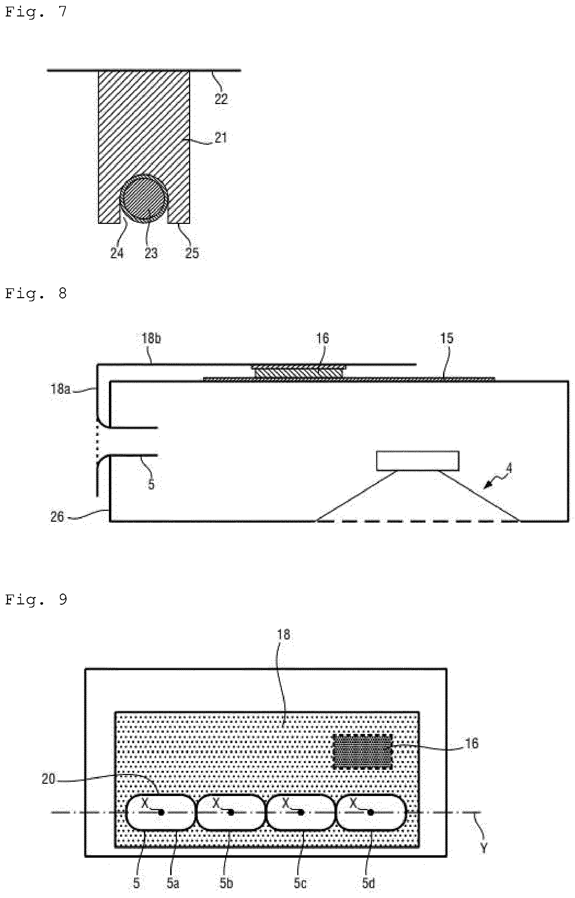

En référence à la figure 7, l'une au moins des ailettes 21 comprend un passage de câble qui s'étend selon une longueur de ladite ailette 21 et qui permet d'accueillir un câble 23. Plusieurs ailettes 21 comprennent en l'occurrence chacune un passage de câble.

Les câbles 23 connectent ici par exemple le haut-parleur 4 à un amplificateur situé à l'extérieur du caisson 3.

Cela n'est cependant pas obligatoire : le ou les câbles 23 pourraient parfaitement connecter entre eux des composants autres qu'un haut-parleur et un amplificateur.

Chaque passage de câble comprend en l'occurrence une gorge 24 formée au niveau de la surface supérieure 25 de l'ailette, c'est-à-dire de la surface opposée à la surface interne 22 de l'évent 5 depuis laquelle s'étend ladite ailette.

La gorge 24 permet l'insertion du câble 23 dans toute la longueur de l'évent 5. La gorge 24 maintient le câble 23 par pincement. Ceci permet de faire passer le câble 23 par l'évent 5, pour ne pas avoir à gérer un passage du câble 23 au travers du caisson et ainsi éviter les problématiques d'étanchéité.

Le câble 23, lisse ou rugueux, doit être suffisamment souple pour s'encastrer dans la gorge 24 et y être maintenu en force. Le matériau de l'évent 5 tel qu'évoqué précédemment permet d'assurer que l'ailette 21 est suffisamment résistante pour maintenir le câble sans se déformer. Enfin, la prolongation du dispositif de dissipation thermique 17 en sortie d'évent 5 peut être mise à contribution pour guider le câble 23 jusqu'au composant situé à l'extérieur du caisson 3 et auquel il est connecté.

La gorge 24 présente ici un resserrement à sa sortie (et possiblement à son entrée), afin de supprimer les risques de « sortie » du câble 23 lors de l'utilisation normale du produit.

On note que, lorsque le câble 23 s'étend dans la gorge 24, la surface de la section « pleine » de l'ailette 21 selon un plan perpendiculaire à l'axe longitudinale de l'ailette 21, c'est-à-dire la somme de la surface de la section de l'ailette 21 et de la surface de la section du câble 23, est presque égale à la surface de la section qu'aurait l'ailette 21 sans la gorge 24. Ainsi, la présence de la gorge 24 et du câble 23 ne modifie pas la formule de la fréquence de résonance de l'évent 5 fournie précédemment, ce qui facilite le dimensionnement et la conception du dispositif de dissipation thermique 17.

De nombreuses variantes sont possibles.

En référence à la figure 8, l'évent 5 pourrait s'étendre au travers d'une autre face du caisson 3, et par exemple au travers de la face arrière 26.

Le composant 16 à refroidir et la carte électrique 15 sur laquelle il est monté peuvent être situés sur le dessus du caisson 3. Dans ce cas, l'évent 5 est prolongé dans sa partie externe par une première plaque 18a puis par une deuxième plaque 18b perpendiculaire à la première plaque 18a, la deuxième plaque 18b recouvrant intégralement la surface du composant 16. La première plaque 18a et la deuxième plaque 18b (et l'évent 5) peuvent être formées par une pièce unique, mais cela n'est pas nécessairement le cas.

La ou les plaques 18 pourraient former une portion (ou la totalité) d'une ou de plusieurs faces du caisson 3.

Dans une autre variante, la hauteur des ailettes 21 peut également être prolongée jusqu'à avoir plusieurs tuyaux dont la somme des sections est égale à la section de l'évent initial.

En référence à la figure 9, l'enceinte 2 comprend ainsi une pluralité d'évents.

Les évents peuvent être « jointifs » (par exemple par l'une de leurs parois), ou peuvent être non-jointifs.

Ici, l'enceinte comprend quatre évents 5a, 5b, 5c, 5d. Les axes longitudinaux X des évents 5 sont parallèles entre eux et sont perpendiculaire au plan dans lequel s'étend la plaque 18.

Comme précédemment, la section de chaque évent 5 selon un plan perpendiculaire à son axe longitudinal X est oblongue. Le contour 20 de chaque évent 5 présente la forme d'un rectangle dont les largeurs sont arrondies et dont les longueurs sont parallèles à la longueur du boîtier décodeur 1.

Les évents sont alignés et s'étendent successivement de sorte que les axes longitudinaux Y de leurs contours 20 sont alignés et parallèles à la longueur du boîtier décodeur 1.

Les évents sont positionnés de sorte que les parois externes de deux évents adjacents sont en contact au niveau de la largeur de leur contour 20 : l'évent 5a est en contact avec l'évent 5b qui est aussi en contact avec l'évent 5c qui est aussi en contact avec l'évent 5d.

Les parois, qui peuvent être confondues à l'endroit de la surface de contact, jouent le rôle des ailettes présentées plus tôt.

Cette configuration permet de maximiser les surfaces d'échange avec l'air. Cette variante peut être utilisée dans le cas où la mise en place des ailettes 21 est trop complexe, par exemple si le matériau est trop souple ou si l'usinage d'ailettes n'est pas possible.

Bien entendu, l'invention n'est pas limitée aux modes de réalisation décrits mais englobe toute variante entrant dans le champ de l'invention tel que défini par les revendications.

L'équipement électrique dans lequel est mise en oeuvre l'invention n'est pas nécessairement un boîtier décodeur, mais peut être tout équipement comprenant une enceinte acoustique et des composants électroniques : enceinte connectée, assistant vocal, téléviseur, etc.

Bien sûr, la plaque de dissipation 18 peut être couplée thermiquement avec plusieurs composants électroniques.

La plaque pourra éventuellement être pourvue de nervures/ailettes afin d'augmenter la surface de dissipation.

La plaque et le composant à refroidir pourraient être situés à l'intérieur du caisson ; dans ce cas, la plaque s'étend depuis l'extrémité 9 de l'évent 5.

Le dispositif de dissipation thermique pourrait comprendre deux plaques qui s'étendent chacune depuis une extrémité distincte de l'évent : une plaque positionnée à l'extérieur du caisson et une autre à l'intérieur du caisson, chaque plaque étant couplée thermiquement avec au moins un composant électronique.

L'élément conducteur thermique, qui s'étend depuis une extrémité de l'évent, n'est pas nécessairement une plaque mais peut présenter une forme quelconque.

L'évent et l'élément conducteur thermique peuvent être conçus en plusieurs pièces distinctes, liées par une liaison thermique adéquate (contact direct ou moyen de liaison thermique, par exemple pad thermique). Il est alors possible d'avoir des matériaux différents entre ces deux parties, comme par exemple de l'aluminium ou du cuivre pour le dissipateur, et un plastique ABS pour l'évent. Ceci permet de réduire le coût global de fabrication par rapport à une solution entièrement en métal (le plastique ABS étant plus facile à usiner pour des formes complexes).

Le moyen thermique pouvant coupler thermiquement le composant à refroidir et l'élément conducteur thermique n'est pas nécessairement un pad : il pourrait s'agir par exemple de pâte thermique, voire de résine époxy thermo-conductrice.

Le passage de câble associé à une ailette n'est pas nécessairement une gorge. Il pourrait s'agir par exemple d'un conduit tubulaire formé à l'intérieur de l'ailette, ou bien de moyens de fixation tels que des crochets positionnés sur une face de l'ailette.

Le passage de câble n'est pas forcément associé à une seule ailette. Le passage de câble peut être formé sur ou dans une (seule) ailette, ou bien entre deux ailettes adjacentes, le passage de câble s'étendant selon une longueur de ladite ou desdites ailettes. Le passage de câble peut ainsi par exemple être constitué de deux ailettes rapprochées permettant de pincer le câble entre les deux ailettes. Les faces de ces ailettes situées du côté de l'insertion du câble peuvent éventuellement être nervurées afin d'aider au maintien du câble.

**Revendications**

1.  Equipement (1) comportant :

    - une enceinte acoustique (2) comprenant un caisson (3), un haut-parleur (4) et un évent (5) ;
    - un composant électronique (16) ;
    - un dispositif de dissipation thermique (17) agencé pour dissiper une chaleur générée par le composant électronique, et comprenant l'évent (5) ainsi qu'un élément conducteur thermique (18) qui s'étend depuis une extrémité (8) de l'évent et qui est couplé thermiquement avec le composant électronique, l'évent comprenant des ailettes (21) qui s'étendent depuis une surface interne (22) de l'évent et parallèlement à un axe longitudinal (X) de l'évent, l'équipement étant **caractérisé en ce qu'**il comporte un câble (23) et un passage du câble formé sur ou dans une ailette, ou entre deux ailettes adjacentes, le passage du câble s'étendant selon une longueur de ladite ou desdites ailettes.

2.  Equipement selon la revendication 1, dans lequel l'élément conducteur thermique comprend une plaque (18) qui s'étend dans un plan perpendiculaire à un axe longitudinal (X) de l'évent, et dans lequel l'évent s'évase au niveau de ladite extrémité pour déboucher sur ladite plaque conductrice.

3.  Equipement selon la revendication 2, dans lequel le composant électronique est monté sur une carte électrique (15) qui s'étend entre la plaque et une face (6) du caisson, parallèlement à ladite plaque et à ladite face.

4.  Equipement selon l'une des revendications précédentes, dans lequel l'évent (5), lorsqu'il est vu en coupe selon un plan perpendiculaire à un axe longitudinal (X) de l'évent, présente une forme oblongue.

5.  Equipement selon l'une quelconque des revendications 1 à 4, dans lequel une distance *e* entre deux ailettes (21) adjacentes est telle que :

$$e > 2 * h$$

où *h* est une hauteur desdites ailettes (21).

**6.** Equipement selon l'une quelconque des revendications 1 à 5, dans lequel une hauteur de chaque ailettes (21) va en diminuant en se rapprochant des extrémités (8, 9) de l'évent (5) .

**7.** Equipement selon l'une quelconque des revendications 1 à 6, dans lequel le passage du câble comprend une gorge (24) formée au niveau d'une surface (25) d'une ailette, ladite surface étant opposée à la surface interne (22) de l'évent depuis laquelle s'étend ladite ailette.

**8.** Equipement selon la revendication 7 dans lequel, le câble (23) est inséré dans la gorge (24) dans toute la longueur de l'évent (5), la gorge (24) maintenant le câble (23) par pincement.

**9.** Equipement selon l'une des revendications précédentes, comprenant une pluralité d'évents (5a, 5b, 5c, 5d) ayant des axes longitudinaux (X) parallèles.

**10.** Equipement selon la revendication 9, dans lequel la pluralité d'évents comporte au moins deux évents comprenant chacun une paroi en contact ou confondue avec une paroi de l'autre évent.

**11.** Equipement selon l'une des revendications précédentes, dans lequel l'élément conducteur thermique comprend une plaque formant une portion ou la totalité d'une face du caisson.

**12.** Equipement selon l'une des revendications précédentes, dans lequel le couplage thermique entre l'élément conducteur thermique (18) et le composant électronique (16) est réalisé par un moyen de liaison thermique positionné entre l'élément conducteur thermique et le composant électronique (16).

**13.** Equipement selon l'une des revendications précédentes, l'équipement étant un boîtier décodeur (1).

**Patentansprüche**

**1.** Ausrüstung (1) enthaltend:

- eine Lautsprecherbox (2) umfassend einen Korpus (3), einen Lautsprecher (4) und eine Entlüftung (5);
- eine elektronische Komponente (16);

- eine Wärmeableitungsvorrichtung (17), welche derart angeordnet ist, dass sie eine von der elektronischen Komponente erzeugte Wärme ableitet, und welche die Entlüftung (5) sowie ein wärmeleitendes Element (18) umfasst, das sich von einem Ende (8) der Entlüftung aus erstreckt und mit der elektronischen Komponente thermisch verkoppelt ist, wobei die Entlüftung Rippen (21) umfasst, die sich von einer Innenfläche (22) der Entlüftung aus und parallel zu einer Längsachse (X) der Entlüftung erstrecken, wobei die Ausrüstung **dadurch gekennzeichnet ist, dass** sie ein Kabel (23) sowie einen Kabeldurchgang enthält, der an oder in einer Rippe bzw. zwischen zwei benachbarten Rippen ausgebildet ist, wobei sich der Kabeldurchgang entlang einer Länge der einen oder der mehreren Rippen erstreckt.

**2.** Ausrüstung nach Anspruch 1, wobei das wärmeleitende Element eine Platte (18) umfasst, die sich in einer Ebene senkrecht zu einer Längsachse (X) der Entlüftung erstreckt, und wobei sich die Entlüftung an dem oben erwähnten Ende aufweitet und in die leitende Platte mündet.

**3.** Ausrüstung nach Anspruch 2, wobei die elektronische Komponente auf einer elektrischen Leiterkarte (15) montiert ist, die sich zwischen der Platte und einer Fläche (6) des Korpus parallel zu der Platte und der Fläche erstreckt.

**4.** Ausrüstung nach einem der vorhergehenden Ansprüche, wobei die Entlüftung (5) im Querschnitt entlang einer Ebene senkrecht zu einer Längsachse (X) der Entlüftung betrachtet eine längliche Form aufweist.

**5.** Ausrüstung nach einem der Ansprüche 1 bis 4, wobei ein Abstand e zwischen zwei benachbarten Rippen (21) derart gewählt ist, dass:

$$e > 2 * h$$

wobei h eine Höhe der Rippen (21) ist.

**6.** Ausrüstung nach einem der Ansprüche 1 bis 5, wobei eine Höhe aller Rippen (21) mit zunehmender Nähe zu den Enden (8, 9) der Entlüftung (5) abnimmt.

**7.** Ausrüstung nach einem der Ansprüche 1 bis 6, wobei der Kabeldurchgang eine Nut (24) umfasst, die an einer Oberfläche (25) einer Rippe ausgebildet ist, wobei diese Oberfläche der Innenfläche (22) der Entlüftung abgewandt ist, von welcher aus sich die Rippe erstreckt.

**8.** Ausrüstung nach Anspruch 7, wobei das Kabel (23) über die gesamte Länge der Entlüftung (5) hinweg in die Nut (24) eingesetzt ist, wobei das Kabel (23) durch Klemmung in der Nut (24) gehalten wird.

**9.** Ausrüstung nach einem der vorhergehenden Ansprüche, umfassend eine Mehrzahl von Entlüftungen (5a, 5b, 5c, 5d) mit parallel verlaufenden Längsachsen (X).

**10.** Ausrüstung nach Anspruch 9, wobei die Mehrzahl von Entlüftungen zumindest zwei Entlüftungen enthält, die jeweils eine Wand umfassen, welche mit einer Wand der anderen Entlüftung in Kontakt steht oder mit dieser zusammenfällt.

**11.** Ausrüstung nach einem der vorhergehenden Ansprüche, wobei das wärmeleitende Element eine Platte umfasst, welche einen Teilabschnitt oder die Gesamtheit einer Fläche des Korpus bildet.

**12.** Ausrüstung nach einem der vorhergehenden Ansprüche, wobei die thermische Verkopplung zwischen dem wärmeleitenden Element (18) und der elektronischen Komponente (16) durch ein thermisches Verbindungsmittel erzielt wird, das zwischen dem wärmeleitenden Element und der elektronischen Komponente (16) positioniert ist.

**13.** Ausrüstung nach einem der vorhergehenden Ansprüche, wobei es sich bei der Ausrüstung um eine Decoderbox (1) handelt.

**Claims**

**1.** Equipment (1) comprising:

· a speaker enclosure (2) comprising a chamber (3), a loudspeaker (4), and a vent (5);
• an electronic component (16); and
• a heat sink device (17) arranged to dissipate the heat generated by the electronic component and comprising both the vent (5) and also a thermally conductive element (18) that extends from an end (8) of the vent and that is thermally coupled with the electronic component, the vent comprising fins (21) projecting from an inside surface (22) of the vent and extending parallel to a longitudinal axis (X) of the vent, the equipment being **characterized in that** it comprises a cable (23) and a cable passage formed on or in a fin or between two adjacent fins, the cable passage extending along the length of said fin(s).

**2.** Equipment according to claim 1, wherein the thermally conductive element comprises a plate (18) lying in a plane perpendicular to the longitudinal axis (X) of the vent, and wherein the vent flares at said end and opens out in said plate.

**3.** Equipment according to claim 2, wherein the electronic component is mounted on a circuit card (15) that lies between the plate and a face (6) of the chamber, extending parallel to said plate and to said face.

**4.** Equipment according to any preceding claim, wherein when seen in section on a plane perpendicular to its longitudinal axis (X), the vent (5) presents a shape that is oblong.

**5.** Equipment according to any one of claims 1 to 4, wherein two adjacent fins (21) are spaced apart by a distance e such that:

$$e > 2 * h$$

where h is a height of said fins (21).

**6.** Equipment according to any one of claims 1 to 5, wherein each fin (21) is of a height that decreases on approaching the ends (8, 9) of the vent (5).

**7.** Equipment according to any one of claims 1 to 6, wherein the cable passage comprises a groove (24) formed in a surface (25) of a fin, which surface is remote from the inside surface (22) of the vent from which said fin projects.

**8.** Equipment according to claim 7, wherein the cable (23) is inserted in the grove (24) along the entire vent length, the grove (24) maintaining the cable by pinch.

**9.** Equipment according to any preceding claim, including a plurality of vents (5a, 5b, 5c, 5d) having respective longitudinal axes (X) that are parallel.

**10.** Equipment according to claim 9, wherein the plurality of vents includes at least two vents, each having a wall in contact with or coinciding with a wall of the other vent.

**11.** Equipment according to any preceding claim, wherein the thermally conductive element comprises a plate forming an entire face of the chamber, or a portion thereof.

**12.** Equipment according to any preceding claim, wherein the thermal coupling between the thermally conductive element (18) and the electronic component (16) is provided by thermal connection means positioned between the thermally conductive element and the electronic component (16).

**13.** Equipment according to any preceding claim, the equipment being a set-top box (1).

Fig. 1

Fig. 2

Fig. 3

Fig. 4

Fig. 5

Fig. 6

Fig. 7

Fig. 8

Fig. 9

**RÉFÉRENCES CITÉES DANS LA DESCRIPTION**

**Documents brevets cités dans la description**

- US 2020314546 A
- FR 3075546 A1
- FR 2394220 A1
- JP H10164680 A